# EUROPÄISCHE PATENTANMELDUNG

(11) **EP 3 671 230 A1**
(43) Veröffentlichungstag der Anmeldung: **24.06.2020**
(21) Anmeldenummer: 19217600.6
(22) Anmeldetag: 18.12.2019
(51) Int. Cl.: G01R 19/25, G01R 31/00

(54) **MESSEINRICHTUNG ZUR BESTIMMUNG VON EMITTIERTEN STÖRSPANNUNGEN UND STÖRSTRÖMEN IN ELEKTRISCHEN LEITUNGEN**

(30) Priorität: 20.12.2018 DE 102018133208
(71) Anmelder: FUSS-EMV-Ing. Max Fuss GmbH & Co. KG, 12489 Berlin (DE)
(72) Erfinder: Keddig, Volker, 12355 Berlin (DE)
(74) Vertreter: Gulde & Partner

(57) **Zusammenfassung**

Die Erfindung betrifft eine Messeinrichtung (10) zur Bestimmung von Störströmen in elektrischen Leitungen, ein zugehöriges Verfahren und ein zugehöriges Computerprogrammprodukt. Dabei weist die Messeinrichtung zumindest eine Erfassungseinrichtung (20) und eine Auswerteeinrichtung (30) auf. Die Erfassungseinrichtung wiederum weist mindestens ein Messelement (21) zur Erfassung eines Signals, eine Messschaltung (22) zur Aufbereitung des Signals und eine erste Datenschnittstelle (23) zur Übermittlung des Signals an die Auswerteeinrichtung (30), die Auswerteeinrichtung mindestens eine zweite Datenschnittstelle (31) zum Empfang des übermittelten Signals, eine Recheneinheit (32) zur Verarbeitung und Auswertung des übermittelten Signals und eine Anzeigeeinrichtung (33) zur Anzeige des verarbeiteten und ausgewerteten Signals auf.

## Beschreibung

Die Erfindung betrifft eine Messeinrichtung zur Bestimmung von Störspannungen und Störströmen in elektrischen Leitungen und durch die Umgebungsluft, ein zugehöriges Verfahren und ein zugehöriges Computerprogrammprodukt.

Technische Geräte, insbesondere industrielle Maschinen und Anlagen, dürfen nicht durch von anderen Geräten oder Maschinen ausgehende, ungewollte elektrische oder elektromagnetische Effekte gestört werden, oder selbst andere Geräte oder Maschinen stören. Es ist daher üblich, nach dem Aufbau beziehungsweise der Installation eines Gerätes oder einer Maschine, sowie im Rahmen der Wartung und Instandhaltung die funktionale Sicherheit der Geräte und Maschinen zu überprüfen, um mögliche Gefahrenquellen zu erkennen. Die Feststellung von Störeffekten kann auch im Rahmen einer Netzwerkdiagnose erfolgen.

Das Fehlen solcher Störeffekte auf andere Geräte und Maschinen, sowie eine hinreichende Widerstandskraft gegen solche Störeffekte wird als elektromagnetische Verträglichkeit (abgekürzt "EMV") bezeichnet und ist in einer Vielzahl von Richtlinien und Normen geregelt.

Die genannten Störeffekte können beispielsweise elektrische, magnetische oder elektromagnetische Felder oder Vorgänge sein. Dazu gehören auch sogenannte Störspannungen und Störströme auf den Verbindungsleitungen zwischen elektrischen Komponenten oder elektrischen Bauteilen von Geräten oder Maschinen, die durch einfallende Störfelder erzeugt werden. Nachfolgend soll der Begriff Störstrom auch Störspannungen einschließen.

Aus dem Stand der Technik sind verschiedene Geräte und Werkzeuge bekannt, um die elektromagnetische Verträglichkeit zu bestimmen beziehungsweise zu prüfen. Hauptsächlich werden dafür Störpegelmessempfänger und Netzanalyser verwendet, oft auch mit einem so genannten Zangenstrommesser, auch als Stromzange bezeichnet, die einen möglichen Störstrom oder eine mögliche Störspannung detektieren und das Ergebnis in ein Messgerät = Störpegelmessempfänger oder Netzwerkanalyser liefert.

In den Messgeräten werden die detektierten Signale verarbeitet und in den entsprechenden Frequenzbändern angezeigt.

Dabei gibt es Geräte mit recht kleinen Anzeigen, die zwar handlich, aber schlecht abzulesen sind. Oft wird nur ein Zahlenwert ausgegeben, der mittels eines geräteabhängigen Übersetzungsverhältnisses umgerechnet werden muss, um die wahre Größe des Stroms beziehungsweise der Spannung zu bestimmen. Andere Geräte weisen eine größere Anzeige auf, werden dadurch aber schwer und unhandlich, und oft auch teuer. Zudem steigt der Energiebedarf solcher Geräte mit größerer Anzeige.

Es ist daher Aufgabe der Erfindung, eine Vorrichtung zur Bestimmung von Störströmen in elektrischen Leitungen vorzuschlagen, die einfach zu bedienen, handlich und kostengünstig sind.

Die Aufgabe der Erfindung wird gelöst durch eine Messeinrichtung nach Anspruch 1, ein Verfahren nach Anspruch 10 und ein Computerprogrammprodukt nach Anspruch 11. Bevorzugte Ausgestaltungen und Weiterentwicklungen werden in den untergeordneten Ansprüchen offenbart.

In einer ersten Ausführungsform weist eine Messeinrichtung zur Bestimmung von Störströmen in elektrischen Leitungen mindestens eine Erfassungseinrichtung und eine Auswerteeinrichtung auf.

Die mindestens eine Erfassungseinrichtung wiederum weist zumindest ein Messelement, eine Messschaltung und eine erste Datenschnittstelle auf. Das Messelement ist signalleitend mit der Messchaltung und die Messschaltung signalleitend mit der ersten Datenschnittstelle verbunden. Dabei soll signalleitend so verstanden werden, dass die Daten von einem Element oder einer Einrichtung der erfindungsgemäßen Messeinrichtung beziehungsweise Erfassungseinrichtung übertragen werden, also von einem Element oder einer Einrichtung an ein anderes Element oder eine andere Einrichtung weiteregegeben werden können. Dies kann drahtgebunden und/oder drahtlos erfolgen.

Das Messelement dient zur Erfassung eines zu messenden Signals, welches in analoger Form erfasst wird. Die Messschaltung empfängt das erfasste Signal vom Messelement und bereitet dieses auf. Das aufbereitete Signal wird an die erste Datenschnittstelle übermittelt, die zur Übermittlung, also Übertragung des aufbereiteten Signals an die Auswerteeinrichtung ausgebildet ist.

Die mindestens eine Auswerteeinrichtung weist zumindest eine zu der ersten Datenschnittstelle korrespondierende zweite Datenschnittstelle zum Empfang des übermittelten Signals, eine Recheneinheit zur Verarbeitung und Auswertung des übermittelten Signals, die signalleitend mit der zweiten Datenschnittstelle verbunden ist, und eine mit der Recheneinheit signalleitend verbundene Anzeigeeinrichtung zur Anzeige des ausgewerteten Signals auf. Die Auswerteeinrichtung kann dabei zusätzlich auch ein Speicherelement aufweisen.

Unter korrespondierender Datenschnittstelle soll dabei im Sinne der vorliegenden Erfindung verstanden werden, dass die erste Datenschnittstelle und die zweite Datenschnittstelle ausgebildet sind, dieselben Kommunikationsprotokolle auszuführen und so direkt und ohne zusätzliche Hilfsmittel Daten und Informationen miteinander auszutauschen.

Verarbeitung und Auswertung eines übermittelten Signals soll dabei so verstanden werden, dass die übermittelten Signale in die Recheneinheit eingespeist werden. Dort kann eine Befehlsfolge beziehungsweise eine Software hinterlegt sein, die die übermittelten Signale mithilfe von Berechnungen und/oder Vergleichswerten analysiert und so eine Aussage über das Vorhandensein und/oder die Größe eines Störstroms und/oder einer Störspannung ermöglicht. Diese Aussage kann in Form von Zahlen, Buchstaben beziehungsweise Wörtern, grafisch durch Diagramme und/oder mittels Farben über die Anzeigeeinrichtung an einen Benutzer übermittelt werden.

Es ist ohne weiteres erkennbar, dass eine Messeinrichtung sowohl mehrere Erfassungseinrichtungen in Verbindung mit einer einzigen Auswerteeinrichtung, oder eine Erfassungseinrichtung in Verbindung mit einer Vielzahl von Auswerteeinrichtungen, aber auch eine Vielzahl von Erfassungseinrichtungen in Verbindung mit einer Vielzahl von Auswerteeinrichtungen aufweisen kann.

Die Messschaltung zur Aufbereitung des erfassten analogen Signals kann in einer Ausführungsform ein gemessenes Signal verstärken, invertieren und/oder in ein digitales Signal umwandeln. Die Messschaltung kann also beispielsweise ein Analog-Digital-Wandler sein. Diesem kann ein Verstärker vorgeschaltet sein. Die Messschaltung kann auch eine Kombination aus einem ersten Analog-Digital-Wandler mit einem Verstärker und einen zweiten Analog-Digital-Wandler, dem ein Inverter und ein Verstärker vorgeschaltet ist, aufweisen. Dem Fachmann ist bekannt, dass der Verstärker dem Inverter auch vorgeschaltet sein kann. Eine solche Kombination erlaubt die bedarfsgerechte Auswahl der Analog-Digital-Wandler, so dass diese einen eher kleinen Arbeitsbereich beziehungsweise eine eher geringe Auflösung aufweisen müssen und somit kostengünstiger sind. Vorteilhafterweise werden bei einer solchen Kombination die Signale der beiden Analog-Digital-Wandler in gleichem Maße verstärkt. Die vorstehend beschriebenen Veränderungen des erfassten Signals sind im Rahmen der Erfindung als Aufbereitung des Signals zu verstehen.

In einer nächsten Ausführungsform kann die Erfassungseinrichtung eine Recheneinheit zur Vorverarbeitung der aufbereiteten Signale aufweisen. Dabei ist die Recheneinheit signalleitend mit der Messschaltung und ebenfalls signalleitend mit der ersten Datenschnittstelle verbunden. Mit anderen Worten ist sie zwischen die Messschaltung und die erste Datenschnittstelle zwischengeschalten. Die erste Datenschnittstelle kann dabei ausschließlich der Recheneinheit nachgeschalten sein, sie kann aber auch signalleitend mit der Messschaltung und mit der Recheneinheit verbunden sein. Unter Vorverarbeitung der Signale soll beispielsweise eine Vorauswahl oder Filterung der aufbereiteten Signale und/oder eine erste Abschätzung über das Vorhandensein und/oder die Höhe des Störstroms verstanden werden.

In einer übernächsten Ausführungsform kann die Erfassungseinrichtung ein Speicherelement aufweisen. Darauf können die aufbereiteten Signale der Messschaltung und/oder aber die vorverarbeiteten Signale der Recheneinheit gespeichert werden. Dazu sollte das Speicherelement mit der Messschaltung beziehungsweise mit der Recheneinheit signalleitend verbunden sein. Insbesondere kann das Speicherelement ein Datenlogger sein. Ein Datenlogger ist üblicherweise eine prozessorgesteuerte Speichereinheit, welche Daten in einem bestimmten Rhythmus über eine Schnittstelle, im vorliegenden Fall zu der Messschaltung und/oder der Recheneinheit, aufnimmt und auf einem Speichermedium ablegt.

Weiterhin kann eine erfindungsgemäße Erfassungseinrichtung eine Anzeigeeinrichtung aufweisen. Diese kann beispielsweise als Display oder in Form von Leuchtdioden (LED) ausgebildet sein. Sie sollte signalleitend mit der Recheneinheit der Erfassungseinrichtung verbunden sein. Damit wird erreicht, dass die aufbereiteten Daten und/oder die vorverarbeiteten Daten schon am Gerät angezeigt werden können. So kann in einer Anzeige ein Zahlenwert und/oder eine Buchstabenfolge ausgegeben werden, die auf einen Störstrom schließen lassen. Alternativ kann über die Farbe und/oder das Aufleuchten einer oder mehrerer LEDs in einem definierten Rhythmus auf einen solchen Störstrom schließen lässt.

In einer weiteren Ausführungsform können die Erfassungseinrichtung und die Auswerteeinrichtung räumlich voneinander getrennt ausgebildet sein. Sie sind also mit anderen Worten räumlich voneinander beabstandet und können dabei an verschiedenen Orten angeordnet sein. Dies ermöglicht es, die Erfassungseinrichtung möglichst klein und kompakt, und damit auch handlich und kostengünstig herzustellen. Insbesondere in Verbindung mit einem Speicherelement können Signale an einem oder mehreren Messpunkten zunächst erfasst und in der Erfassungseinrichtung gespeichert werden, und zu einem anderen Zeitpunkt an die Auswerteeinrichtung übermittelt werden.

Zusätzlich oder alternativ kann die Übermittlung des aufbereiteten Signals zwischen der ersten und der zweiten Datenschnittstelle, also der Erfassungseinrichtung und der Auswerteeinrichtung, drahtgebunden oder drahtlos, insbesondere über WLAN oder Bluetooth erfolgen. Es ist aber auch jedes andere Kommunikationsprotoll denkbar, dass eine Übermittlung von Signalen von der ersten an die zweite Datenschnittstelle ermöglicht.

Dabei kann die Erfassungseinrichtung ein Bedienelement aufweisen, mit dem die Datenübermittlung von der Erfassungseinrichtung an die Auswerteeinrichtung manuell durch einen Benutzer ausgelöst werden kann. Selbstverständlich kann dieses Bedienelement auch zum Beenden der Übermittlung dienen. Das Bedienelement muss dazu signalleitend mit der Recheneinheit und mit der ersten Datenschnittstelle verbunden sein. Mit dieser Ausführungsform ist es möglich, dass die Erfassungseinrichtung nicht dauerhaft Signale aussendet, die an eine Auswerteeinrichtung übermittelt werden sollen, sondern die Übermittlung kann dann manuell ausgelöst werden. Dies ist besonders sinnvoll, wenn die Messwerte, wie oben bereits beschrieben, an einem oder mehreren Messpunkten erfasst werden, aber die Auswerteeinrichtung an einem anderen Ort befindlich ist. Alternativ oder zusätzlich kann die Erfassungseinrichtung auch zum dauerhaften Übermitteln von Signalen ausgebildet sein.

Ein Anwendungsfall für das manuelle Auslösen der Übermittlung von Signalen wäre die Erfassung und Speicherung von Signalen an einer Vielzahl von Messpunkten in einer Industrieanlage, bei der die Signale auch vorverarbeitet werden können. Währenddessen bleibt in diesem Beispiel die Übermittlung ausgeschaltet. Nach Abschluss der Messungen wird die Erfassungseinrichtung in die Nähe der Auswerteeinrichtung gebracht, beispielsweise in das Büro des Messtechnikers, um dort mittels des Bedienelements die Übermittlung der Signale von der Erfassungseinrichtung an die Auswerteeinrichtung zu starten. Dieser Anwendungsfall hat den Vorteil, dass durch die abgeschaltete Übermittlung während der Messungen keine Signale ausgesendet werden, die zu einer Störung der Messung führen könnten.

Eine Auswerteeinrichtung kann im Sinne der Erfindung beispielsweise ein Smartphone, ein Tablet, ein Personal Computer (PC) oder dergleichen sein.

Die Messeinrichtung kann im Sinne der Erfindung auch als Zangenstrommesser, also als Stromzange, in Kombination mit einem Smartphone, einem Tablet und/oder einem PC ausgebildet sein, wobei der Zangenstrommesser die Erfassungseinrichtung bildet und das Smartphone, das Tablet und/oder der PC die Auswerteeinrichtung(en).

In einem erfindungsgemäßen Verfahren zur Bestimmung von Störströmen in elektrischen Leitungen mit einer Messeinrichtung mittels einer erfindungsgemäßen Messeinrichtung wird mittels des Messelements der Erfassungseinrichtung ein zu messendes elektrisches Signal in analoger Form erfasst und das gemessene Signal an die Messschaltung übermittelt. Die Messschaltung bereitet das Signal auf, beispielsweise durch Invertieren, Verstärken und/oder Umwandlung des analogen Signals mittels Analog-Digital-Wandler in ein digitales Signal. Das aufbereitete Signal wird an die erste Datenschnittstelle übermittelt, die das aufbereitete Signal an die Auswerteeinrichtung übermittelt.

Das Signal wird in der Auswerteeinrichtung durch die zweite Datenschnittstelle empfangen und an die Recheneinheit übermittelt, die die übermittelten Signale verarbeitet und auswertet. Die verarbeiteten und ausgewerteten Signale werden an die Anzeigeeinrichtung übermittelt und von dieser ausgegeben.

In einer Ausführungsform des erfindungsgemäßen Verfahrens kann während der Verarbeitung und Auswertung der übermittelten Signale durch die Recheneinheit der Auswerteeinrichtung eine Überwachung von Messwerten durchgeführt werden, bei der auch die Einhaltung, Überschreitung und/oder Unterschreitung von Grenzwerten überwacht werden kann.

Erfindungsgemäß wird auch ein Computerprogrammprodukt offenbart, enthaltend eine auf einem maschinenlesbaren Träger gespeicherte Befehlsfolge zum Ansteuern der vorstehend beschriebenen Messeinrichtung und/oder zum Durchführen des vorstehend offenbarten Verfahrens, wenn das Computerprogrammprodukt in einer Recheneinheit abläuft. Dabei kann ein solches Computerprogrammprodukt sowohl auf der Recheneinheit der Auswerteeinrichtung ablaufen, als auch auf der optional vorhandenen Recheneinheit der Erfassungseinrichtung oder auf beiden Recheneinheiten.

Das Computerprogrammprodukt kann dabei vorzugsweise vom Nutzer definierbare Messzyklen, Warnungen, Hilfestellungen, Anleitungen, Grenzwerte nach den Normen EN, Referenzwerte und/oder zeitabhängige und/oder ortsabhängige Übermittlungsregeln beinhalten. So kann der Benutzer beim Messen möglicher Störströme unterstützt werden, so dass beispielsweise auch unerfahrene Nutzer eine solche Messung durchführen können. Die zeit- und/oder ortsabhängigen Übermittlungsregeln ermöglichen es, dass die Übermittlung der erfassten und aufbereiteten, gegebenenfalls vorverarbeiteten Signale zu definierten Zeiten (zeitabhängig), also beispielsweise nach Feierabend, und/oder nach der Rückkehr ins Büro (ortsabhängig) übermittelt werden und so ein manuelles Auslösen oder eine dauerhafte Übertragung der Signale nicht notwendig ist. Die Ortsinformation kann dabei zum Beispiel über die Ortsbestimmung der Auswerteeinrichtung, konkret eines Smartphones oder eines PCs, oder aber durch die Erkennung von Peripheriegeräten, wie beispielsweise einer Ladestation für die Erfassungseinrichtung, erfolgen.

Mit der erfindungsgemäßen Messeinrichtung, dem zugehörigen Verfahren und dem zugehörigen Computerprogrammprodukt können die Funktionalitäten von Erfassungseinrichtung und Auswerteeinrichtung voneinander getrennt werden. Dies wiederum ermöglicht es, kleine, handliche und kostengünstige Geräte als Erfassungseinrichtung zu konzipieren und herzustellen, die auf die notwendigsten technischen Anforderungen beschränkt sind. Für die Auswerteeinrichtung können vorhandene Geräte, wie beispielsweise Smartphones, Tablets und PCs verwendet werden, die mit Hilfe des erfindungsgemäßen Computerprogrammproduktes - das beispielsweise als APP bereitgestellt wird - die Verarbeitung und Auswertung von Signalen durchführen. Demnach muss keine teure Rechenleistung in den Erfassungseinrichtungen vorgesehen oder für die Verarbeitung der erfassten und aufbereiteten Signale bereitgestellt werden. Die Erfassungseinrichtung selbst ist hierdurch auch kostengünstig gestaltbar.

Nachfolgend soll die erfindungsgemäße Messeinrichtung anhand eines Beispiels weiter erläutert werden.

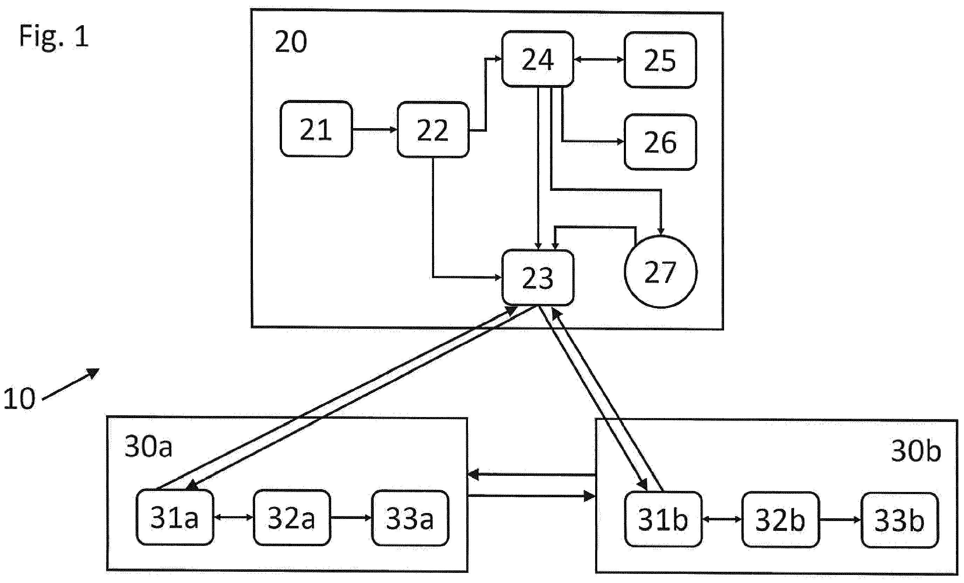

Dazu zeigt
- Figur 1: eine schematische Darstellung einer beispielhaften Ausführungsform.

Figur 1 zeigt eine beispielhafte Ausführungsform der erfindungsgemäßen Messeinrichtung 10 in schematischer Darstellung. Dabei wird die Messeinrichtung 10 mit einer Erfassungseinrichtung 20 und zwei Auswerteeinrichtungen 30a, 30b gebildet. Beispielsweise kann die Auswerteeinrichtung 30a ein Smartphone, und die Auswerteeinrichtung 30b ein PC sein.

Die Erfassungseinrichtung 20 weist in dieser beispielhaften Ausführungsform ein Messelement 21 auf, das zur Erfassung von möglichen Störsignalen dient. Bei einer Ausführung der Erfassungseinrichtung als Stromzange wären dies die Schenkel des Zangenkopfes, die um eine zu vermessende Leitung geschlossen werden.

Das Messelement 21 ist signalleitend mit einer Messschaltung 22 verbunden. In dieser Messschaltung 22 sind ein Verstärker und ein Analog-Digital-Wandler vorgesehen, welche die zuvor erfassten, analogen Signale verstärken und in digitale Signale umwandeln, im Sinne der Erfindung also aufbereiten. Selbstverständlich kann die Messschaltung 22 auch wesentlich komplexer aufgebaut sein, um die Signale optimal für die weitere Verwendung aufzubereiten.

Die Messschaltung 22 ist wiederum signalleitend mit einer ersten Datenschnittstelle 23 verbunden, die ausgebildet ist, die aufbereiteten Signale an die Auswerteeinrichtungen 30a, 30b zu übermitteln.

Zusätzlich ist ein der beispielhaften Ausführungsform in der Erfassungseinrichtung 20 eine Recheneinheit 24 und ein signalleiten damit verbundenes Speicherelement 25 vorgesehen. Dabei ist zudem die Recheneinheit 24 mit der Messschaltung 22 signalleitend verbunden. Damit werden die aufbereiteten Signale vorverarbeitet, so dass über die ebenfalls in der Erfassungseinrichtung vorgesehene Anzeigeeinrichtung 26 in Form von LEDs eine erste Information über das Vorhandensein von Störströmen an den Benutzer übermittelt werden kann. Beispielsweise kann ein Aufleuchten der LEDs in Rot das Vorliegen eines Störstromes anzeigen. Die Anzeigeeinrichtung 26 ist dazu signalleitend mit der Recheneinheit 24 verbunden.

Weiterhin ist das Speicherelement 25 so mit der Recheneinheit 24 verbunden, dass nicht nur aufbereitete und/oder vorverarbeitete Signale in dem Speicherelement 25 abgelegt, sondern auch von diesem durch die Recheneinheit 24 abgerufen werden können, um sie dann an die erste Datenschnittstelle 23 und von dort an die Auswerteeinrichtungen 30a, 30b zu übermitteln. Dies wird durch den Doppelpfeil zwischen Speicherelement 25 und Recheneinheit 24 in Figur 1 veranschaulicht.

Die Übermittlung von der Erfassungseinrichtung 20 an die Auswerteeinrichtungen 30a, 30b erfolgt beispielsweise über Bluetooth, könnte aber auch per WLAN oder Kabel erfolgen.

Die Auswerteeinrichtung 30a ist ein Smartphone bekannter Art, auf dem ein Computerprogrammprodukt zur Durchführung des erfindungsgemäßen Verfahrens und zur Steuerung der Messeinrichtung 10 hinterlegt ist. Im Bezug auf Smartphones werden derartige Computerprogrammprodukte häufig als "App" bezeichnet. Dem Fachmann ist damit klar, dass die Kommunikation zwischen der Auswerteeinrichtung 30a beziehungsweise jeder weiteren Auswerteeinrichtung 30 sowohl zur Übermittlung von Signalen von der Erfassungseinrichtung 20 an die Auswerteeinrichtung(en) 30, als auch zur Übermittlung von Steuerbefehlen von der (den) Steuereinrichtung(en) 30 an die Auswerteeinrichtung 20 erfolgen kann. Dies wird in Figur 1 durch die jeweils zwei Pfeile zwischen der Erfassungseinrichtung 20 an die Auswerteeinrichtungen 30a, 30b veranschaulicht.

Die Auswerteeinrichtung 30b ist ein PC bekannter Art. Auch in der Auswerteeinrichtung 30b ist ein Computerprogrammprodukt zur Durchführung des erfindungsgemäßen Verfahrens und zur Steuerung der Messeinrichtung 10 hinterlegt.

In der Erfassungseinrichtung 20 ist ein Bedienelement 27 vorgesehen, bei dessen Betätigung die Übertragung der Signale von der Erfassungseinrichtung 20 an die Auswerteeinrichtungen 30a, 30b gestartet wird und auch beendet werden kann. Es muss dazu signalleitend mit der Recheneinheit 24 und mit der ersten Datenschnittstelle 23 verbunden sein.

Die übermittelten Signale werden in den Auswerteeinrichtungen 30a, 30b von der jeweiligen zweiten Datenschnittstelle 31a, 31b empfangen und an die jeweilige Recheneinheit 32a, 32b übermittelt, wo sie verarbeitet und ausgewertet. Das Ergebnis der Auswertung, beispielsweise in Form von Zahlenwerten, die die Messwerte repräsentieren, und ein Vergleich mit Grenzwerten, werden in Form von Zahlen und Diagrammen auf den jeweiligen damit verbundenen Anzeigeeinrichtungen 33a, 33b ausgegeben.

Bei der Umsetzung dieses Ausführungsbeispiels kann erreicht werden, dass ein kleines, handliches Gerät als Erfassungseinrichtung ausgebildet wird, welches zudem kostengünstig ist. Mit einem Smartphone als Auswerteeinrichtung 30a, was der Benutzer häufig sowieso bei sich führt, kann der Benutzer vor Ort an den Messpunkten durch die Anzeigeeinrichtung 26 eine erste Tendenz hinsichtlich eines möglichen Störstroms erkennen, und auf dem Smartphone 30a detailliertere Auswertungen einsehen. Durch die Übermittlung der Signale an den PC 30b kann eine weitere, möglicherweise detaillierte Auswertung, der Vergleich mit früheren Messungen und auch die Dokumentation der Messreihen erfolgen.

Zusätzlich zu der Übermittlung von Signalen zwischen Erfassungseinrichtung 20 und den Auswerteeinrichtungen 30a, 30b können auch die Auswerteeinrichtungen 30a, 30b untereinander Daten und Informationen austauschen, beispielsweise über WLAN, Bluetooth oder das Mobilfunknetz. So könnten zum Beispiel noch während der Messungen Messwerte vom Smartphone 30a an den PC 30b übermittelt werden. In Figur 1 wird dies durch die beiden Pfeile zwischen den Auswerteeinrichtungen 30a, 30b veranschaulicht.

### Bezugszeichen

- 10: Messeinrichtung
- 20: Erfassungseinrichtung
- 21: Messelement
- 22: Messschaltung
- 23: erste Datenschnittstelle
- 24: Recheneinheit der Erfassungseinrichtung 20
- 25: Speicherelement der Erfassungseinrichtung 20
- 26: Anzeigeeinrichtung der Erfassungseinrichtung 20
- 27: Bedienelement der Erfassungseinrichtung 20
- 30: Auswerteeinrichtung
- 31: zweite Datenschnittstelle
- 32: Recheneinheit der Auswerteeinrichtung 30
- 33: Anzeigeeinrichtung der Auswerteeinrichtung 30

Messeinrichtung = Stromzange oder Messsensor
Erfassungseinrichtung = APP mit Erfassungstools
Auswerteeinrichtung = APP mit Rechenalgorithmus und Auswerteformeln (SoII/Ist Vergleich)

## Patentansprüche

1. Messeinrichtung (10) zur Bestimmung von Störströmen in elektrischen Leitungen, die mindestens eine Erfassungseinrichtung (20) und mindestens eine Auswerteeinrichtung (30) umfasst, wobei
die mindestens eine Erfassungseinrichtung (20) zumindest
ein Messelement (21) zur Erfassung eines zu messenden elektrischen Signals in analoger Form,
eine Messschaltung (22) zur Aufbereitung des gemessenen Signals, wobei das Messelement (21) und die Messschaltung (22) signalleitend miteinander verbunden sind, und
eine erste Datenschnittstelle (23), die signalleitend mit der Messschaltung (22) verbunden ist, zur Übermittlung des aufbereiteten Signals an die Auswerteeinrichtung (30), aufweist, und
die mindestens eine Auswerteeinrichtung (30) zumindest
eine zu der ersten Datenschnittstelle (23) korrespondierende zweiten Datenschnittstelle (31) zum Empfang des übermittelten Signals,
eine Recheneinheit (32) zur Verarbeitung und Auswertung des übermittelten Signals, die signalleitend mit der zweiten Datenschnittstelle (31) verbunden ist, und
eine mit der Recheneinheit (32) verbundene Anzeigeeinrichtung (33) zur Anzeige des ausgewerteten Signals aufweist.

2. Messeinrichtung (10) nach Anspruch 1,
**dadurch gekennzeichnet, dass**
die Messschaltung (22) ein gemessenes Signal verstärkt, invertiert und/oder in ein digitales Signal umwandelt.

3. Messeinrichtung (10) nach einem der vorhergehenden Ansprüche,
**dadurch gekennzeichnet, dass**
die Erfassungseinrichtung (20) eine Recheneinheit (24) zur Vorverarbeitung der aufbereiteten Signale aufweist.

4. Messeinrichtung (10) nach einem der vorhergehenden Ansprüche,
**dadurch gekennzeichnet, dass**
die Erfassungseinrichtung (20) ein Speicherelement (25), insbesondere einen Datenlogger aufweist.

5. Messeinrichtung (10) nach einem der vorhergehenden Ansprüche,
**dadurch gekennzeichnet, dass**
die Erfassungseinrichtung (20) eine Anzeigeeinrichtung (26) aufweist.

6. Messeinrichtung (10) nach einem der vorhergehenden Ansprüche,
**dadurch gekennzeichnet, dass**
die Erfassungseinrichtung (20) und die Auswerteeinrichtung (30) räumlich voneinander getrennt ausgebildet sind.

7. Messeinrichtung (10) nach einem der vorhergehenden Ansprüche,
**dadurch gekennzeichnet, dass**
die Übermittlung des aufbereiteten Signals zwischen der ersten und der zweiten Datenschnittstelle (23, 31) drahtgebunden oder drahtlos, insbesondere über WLAN oder Bluetooth, erfolgt.

8. Messeinrichtung (10) nach einem der vorhergehenden Ansprüche,
**dadurch gekennzeichnet, dass**
die Erfassungseinrichtung (20) ein Bedienelement (27) zum Auslösen der Datenübermittlung an die Auswerteeinrichtung (30) aufweist.

9. Messeinrichtung (10) nach einem der vorhergehenden Ansprüche,
**dadurch gekennzeichnet, dass**
die Auswerteeinrichtung (30) ein Smartphone, ein Tablet oder ein PC ist.

10. Verfahren zur Bestimmung von Störströmen in elektrischen Leitungen mit einer Messeinrichtung (10) nach einem der vorhergehenden Ansprüche, wobei
mittels des Messelements (21) der Erfassungseinrichtung (20) ein zu messendes elektrisches Signal in analoger Form erfasst und das gemessene Signal an die Messschaltung (22) übermittelt wird,
die Messschaltung (22) das gemessene Signal aufbereitet und an eine erste Datenschnittstelle (23) übermittelt,
und die erste Datenschnittstelle (23) das aufbereitete Signal an die Auswerteeinrichtung (30) übermittelt,
in der Auswerteeinrichtung (30) die zweite Datenschnittstelle (31) das von der ersten Datenschnittstelle (23) übermittelte Signal empfängt und an eine Recheneinheit (32) übermittelt,
die Recheneinheit (32) das übermittelte Signal verarbeitet und auswertet und das ausgewertete Signal an eine Anzeigeeinrichtung (33) übermittelt, und
die Anzeigeeinrichtung (33) das ausgewertete Signal ausgibt.

11. Computerprogrammprodukt, enthaltend eine auf einem maschinenlesbaren Träger gespeicherte Befehlsfolge zum Ansteuern der Messeinrichtung (10) nach einem der Ansprüche 1 bis 9 und/oder zum Durchführen des Verfahrens nach Anspruch 10, wenn das Computerprogrammprodukt in einer Recheneinheit (24, 32) abläuft.
